# EUROPEAN PATENT SPECIFICATION

(11) **EP 1 324 137 B1**
(45) Date of publication and mention of the grant of the patent: **28.02.2007**
(21) Application number: 02258714.1
(22) Date of filing: 18.12.2002
(51) Int. Cl.: G03F 7/20

(54) **Device manufacturing method, device manufactured thereby and lithographic apparatus therefor**
Verfahren zur Herstellung eines Artikels, dabei hergestellter Artikel und lithographischer Apparat dafür
Méthode pour la fabrication d'un dispositif, dispositif fabriqué par le méthode et appareil lithographique associé

(30) Priority: 21.12.2001 EP 01310847
(43) Date of publication of application: 02.07.2003
(73) Proprietor: ASML Netherlands B.V., 5504 DR Veldhoven (NL)
(72) Inventor: Kwan, Yim Bun Patrick, 73437 Aalen (DE)
(74) Representative: Leeming, John Gerard

(56) References cited:
- EP-A- 0 855 623
- EP-A- 1 091 252
- JP-A- 2000 021 715
- US-A- 5 821 034
- US-A- 5 832 620
- US-A1- 2001 036 604
- US-B1- 6 251 564

## Description

An embodiment of the present invention relates to a device manufacturing method comprising the steps of:
providing a substrate that is at least partially covered by a layer of radiation-sensitive material;
providing a projection beam of radiation using a radiation system;
providing a first and a second patterning means which are held on a support structure;
using one of the first and second patterning means to endow the projection beam with a pattern in its cross-section; and
projecting the patterned beam of radiation onto a target portion of the layer of radiation-sensitive material.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. The required matrix addressing can be performed using suitable electronic means. More information on such mirror arrays can be gleaned, for example, from US 5,296,891 and US 5,523,193, which are incorporated herein by reference. In the case of a programmable mirror array, the said support structure may be embodied as a frame or table, for example, which may be fixed or movable as required.
- A programmable LCD array. An example of such a construction is given in US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

In lithography, it becomes more and more important to project smaller features or lines of a pattern on the patterning means onto the substrate. One way to reduce the size of the features is to use radiation having shorter wavelengths than currently available on commercially available lithographic apparatus. Another way to reduce the feature size is to employ extension technology such as multiple exposure in combination with e.g. dipole illumination. By using dipole illumination, only features in a specific orientation are projected onto the substrate with an accuracy that is relatively greater compared to the accuracy obtained using conventional illumination modes like e.g. annular or quadrupole.

As exposure with dipole illumination generally leads to smaller features only in one orientation, the pattern of the patterning means must be split up into two patterns. Generally these patterns are put on two patterning means, whereby a first patterning means only comprises features in a first direction, e.g. a horizontal direction, and a second patterning means comprises features extending in a second direction substantially perpendicular to the first direction e.g. a vertical direction. Both horizontal and vertical directions reside in the plane of the pattern. By first projecting the horizontal features and subsequently projecting the vertical features, the overall feature size will be smaller compared to an exposure of the entire pattern (including horizontal and vertical features) with conventional illumination modes like angular or quadrupole illumination, for example.

In between exposing the first and the second patterns, the first and second patterning means must be exchanged, which consumes time and reduces throughput. In order to decrease throughput reduction, it is generally preferred to expose a whole batch (comprising two or more substrates) with the first patterning means and then expose the same batch with the second patterning means. The advantage is that the first and second patterning means only need exchanging twice per entire batch. Hence, these two exchanges are shared by the whole batch of substrates.

Another method is to expose a first substrate with the first patterning means and subsequently expose the same substrate with the second patterning means before exposing a second substrate. In such case, the patterning means are exchanged twice for each substrate which, of course, results in throughput loss relative to exchanging patterning means twice per entire batch. In EP 0 855 623 A2, it is proposed to put two masks on one mask table, whereby the masks are arranged in line along a scan direction - the scan direction is the direction along which a pattern on a mask is scanned by the projection beam during exposure of a substrate. By using such an arrangement, each target portion on the entire substrate is exposed with the pattern on the first mask, and, subsequently, each target portion is exposed with the pattern on the second mask. As both the first and the second mask are situated on one mask table, exchange of a mask is performed much quicker compared to mask exchange with mask tables comprising only a single mask. Hence, the time needed to perform the mask exchange is reduced and throughput is gained.

Other methods involving double exposures are disclosed in EP 1 091 252-A, US 5,821,034, and US-6,251,564.

In the above-presented methods for multiple exposure, the time between the first and the second exposure is relatively long as at least one entire substrate is exposed with the first patterning means before exposure proceeds with the second patterning means. Consequently, the temperature of the substrate may be different during exposure of the first and second patterning means due to, for example, temperature variations in an environment surrounding the substrate, e.g. a surrounding gas or the substrate table. As a different temperature generally causes expansion or contraction of the substrate, the position of the projected pattern of the second patterning means with respect to the projected pattern of the first patterning means on the substrate (also called overlay) may drift. The extent of drift can be defined by overlay accuracy; a large drift results in a low overlay accuracy and vice versa. Temperature variations of the substrate between exposure of the first and the second patterning means may lead to a low overlay accuracy which is, of course, highly undesirable.

JP-A-2000-021715 discloses a lithographic apparatus using two masks which are held by two independently movable mask tables.

It is an object of the present invention to provide a device manufacturing method for multiple exposure, with which an improved overlay accuracy is established.

According to the present invention, there is provided a device manufacturing method and a lithographic apparatus as defined in the appended claims.

With such a method, a target portion is exposed with both patterns before exposing another target portion. Consequently, the time between projection of the first and the second pattern onto the target portion is minimized. By minimizing the time between the first and second exposure, the influence of temperature variations of the substrate is also reduced. Hence, the drift between the position of features projected during the first and second exposure is reduced and overlay accuracy is improved.

It is further preferable to expose the first and second mask in the same sequence on each target portion. As a dissimilar exposure sequence may introduce differences in feature size or overlay problems due to the intrinsic property of the radiation-sensitive layer, the reproducibility of the pattern on each target portion is enhanced by irradiating each target portion according to the same sequence.

As both patterning means on the mask table are arranged side-by-side in a direction substantially perpendicular to the scan direction, it is possible to perform a method comprising the steps of:
decelerating the mask table in the scan direction following projection of the first pattern;
accelerating the mask table in the direction opposite to the scan direction prior to projection of the second pattern; and
displacing the support structure in a direction substantially perpendicular to the scan direction during decelerating and/or accelerating the mask table such that the second pattern is positioned in line with the direction opposite to the scan direction.

With the above method, after exposure of the first pattern, the mask table moves such that the second pattern can be exposed immediately after the first exposure. In conventional lithographic apparatus with only one patterning means, the pattern on the said means is exposed onto the target portion while scanning the pattern with a certain constant speed. After exposure, the mask table decelerates, stops and accelerates to the said speed in order to expose the pattern onto another target portion but now in a direction opposite to the scan direction. In the method of the present invention, the mask table is displaced in a direction perpendicular to the scan direction while deceleration and/or acceleration proceeds, thereby enabling exposure of the second pattern immediately after the acceleration step. In this way, there is no extra time needed to exchange a patterning means as deceleration and acceleration must be performed anyway. Above all, this method provides a way to perform multiple exposure with high overlay accuracy and without any throughput loss.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle" or "mask", "wafer" or "die" in this text should be considered as being replaced by the more general terms "patterning means", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus,
Figure 2 depicts a mask table provided with two masks according to an embodiment of the present invention,
Figure 3 schematically shows a first method for multiple exposure comprising steps A, B, C and D according to an embodiment of the present invention, and
Figure 4 schematically shows a second method for multiple exposure comprising steps A, B, C and D according to an embodiment of the present invention.

In the Figures, corresponding reference symbols indicate corresponding parts.

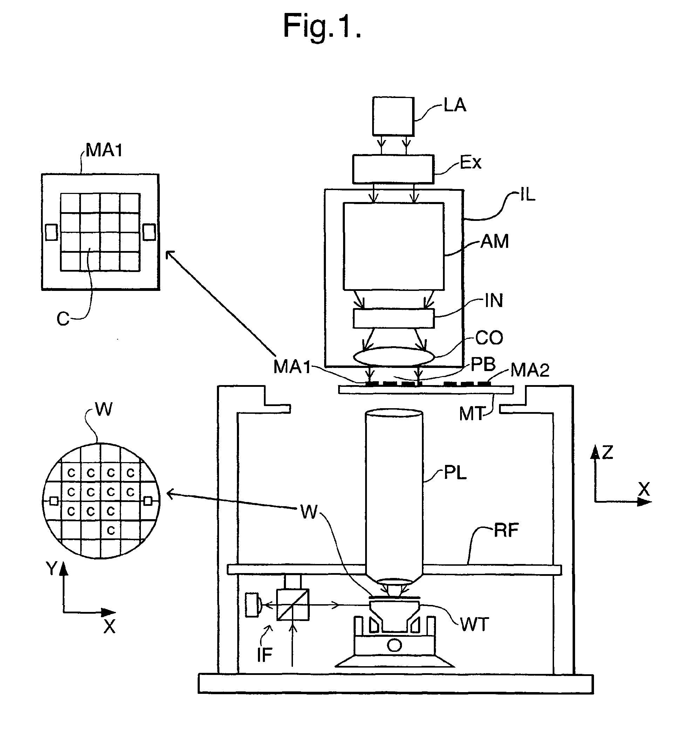

Figure 1 schematically depicts a lithographic projection apparatus according to a particular embodiment of the invention. The apparatus comprises:
· a radiation system Ex, IL, for supplying a projection beam PB of radiation (*e.g.* radiation). In this particular case, the radiation system also comprises a radiation source LA;
· a first object table (mask table) MT provided with a mask holder for holding a first and a second mask MA1 and MA2 (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a refractive or catadioptric system, a mirror group or an array of field deflectors) for imaging an irradiated portion of one of the masks MA1 or MA2 onto a target portion C (*e.g.* comprising one or more dies) of the substrate W.
As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* a Hg lamp, an excimer laser, an undulator or wiggler provided around the path of an electron beam in a storage ring or synchrotron, a laser-produced plasma source, a discharge source or an electron or ion beam source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA1 (or MA2), which is held on a mask table MT. Having traversed the mask MA1, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA1 with respect to the path of the beam PB, *e.g.* after mechanical retrieval of the mask MA1 from a mask library, or during a scan. In general, movement of the object tables MT, WT will be realized with the aid of a long-stroke module (coarse positioning) and a short-stroke module (fine positioning), which are not explicitly depicted in Figure 1.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V* = *Mv,* in which *M* is the magnification of the lens PL (typically, *M* = 1/4 or 1/5). In this manner, a relatively large target portion C can be exposed, without having to compromise on resolution.

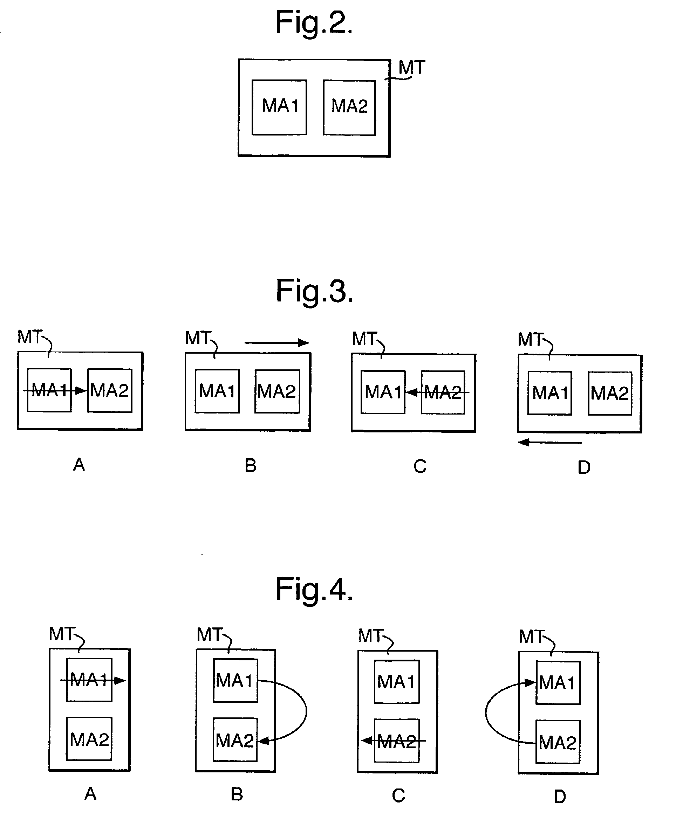

   Figure 2 shows a mask table MT for holding a first and a second mask MA1, MA2. As mentioned previously, such a mask table can be employed for multiple exposure purposes. If a dipole illumination setting is used, only features in a particular direction, e.g. a horizontal or vertical direction, can be imaged with a smaller feature size i.e. a smaller critical dimension. In general, the horizontal and vertical features of a pattern to be projected are separated on two different masks MA1, MA2.
   The horizontal and vertical features must then be exposed in two exposure steps. In multiple exposure methods, the overlay of the features on the different masks and the reproducibility of the critical dimension of these features on the substrate are important. To this end, both mask MA1, MA2 must be projected one immediately after the other on the target portion (or field) before exposing a subsequent target portion; this method may also be referred to as field-by-field double exposure.
   In the step-and-scan apparatus, the steps taken during the double exposure must be carefully chosen in order to accommodate a field-by-field double exposure method having a relatively high overlay accuracy. One method is schematically depicted in Figure
3. In step A, mask MA1 (which is in rest) is first accelerated to a desired velocity. When reaching the required constant velocity, the mask MA1 is exposed and projected onto a first target portion on the substrate. The direction of movement of the mask table MT is referred to as a scan direction. After exposing mask MA1, the mask table MT continues to move with the same velocity and passes mask MA2, whereafter the table MT decelerates and stops completely. This step is indicated by an arrow in step B. In step C the table MT first accelerates to the desired velocity and, subsequently, at this velocity the mask MA2 is irradiated in a direction opposite to the scan direction. The pattern on mask MA2 is projected onto the same target portion as previously irradiated in step A. Following exposure of mask MA2, the mask table MT continues to move at constant velocity and passes mask MA1 analogous to step B. After passing mask MA1, the mask table decelerates and stops. Now, steps A to D can be repeated on a second target portion.

In the mean time, while step B proceeds at mask level, the substrate table WT (shown in Figure 1) just decelerates and stops. Thereafter, the first target portion on the substrate is irradiated backwards concurrently and synchronously with step C. During step D the substrate table WT decelerates and stops, after which it moves to a desired position from which the second target portion is irradiated according to the above cycle of steps.

As the overlay accuracy also depends on the positioning accuracy of either the mask or the substrate, movement of both mask and substrate may introduce positioning errors. The positioning errors on the substrate level are generally relatively larger as positioning errors on the mask level are scaled down on the substrate level by the magnification of the projection lens, which may typically be 1/4 or 1/5. In other words, movement of the substrate table WT must be performed four or five times more accurately than movement at the mask level. Therefore, it is preferable to minimize the number and extent of movements at the substrate level. The above-described method enables minimal movement of the substrate, hence introducing only relatively small overlay errors.

With the described method, it is evident that the exchange from mask MA1 to MA2 (or vice versa) takes time as movement of the mask table in steps B and D requires additional time compared to conventional repeated exposure of just one mask. This inevitably leads to a throughput loss. In another embodiment a method will be presented in which each target portion is irradiated with two masks without any throughput loss.

A second embodiment of the present invention, which is the same as the first embodiment except as described below, is schematically shown in Figure 4. In this case, the masks MA1, MA2 which are held on mask table MT are arranged side-by-side in a direction substantially perpendicular to the scan direction. In this way, it becomes possible to perform step B different from step B of the first embodiment. As the mask table MT is decelerating directly after exposure of mask MA1, the mask table MT concurrently moves to mask MA2 (downward movement in Figure 4). The movement to mask MA2 is continued in order to reach the desired position from which mask MA2 can be irradiated and projected onto the target portion. The desired position (prior to exposure of mask MA2) must be reached before the mask table is accelerated to the required velocity for exposure (in a direction opposite to the scan direction). The above movement is schematically indicated by the arrow in step B of Figure 4. Analogously, step D is performed to enable positioning of the mask table so as to allow immediate exposure of the first mask as soon as the mask table accelerates to the required constant velocity.

Displacement of the mask table in a direction substantially perpendicular to the scan direction may proceed at any stage during deceleration or acceleration in the scan direction. The displacement may start and be finished during deceleration or it may start and be finished during acceleration. Most preferable is that the displacement starts during deceleration and ends during acceleration of the mask table, since in this way unnecessary and undesirable shock or vibrations exerted on the mask table due to fast acceleration or fast deceleration during this displacement are minimized.

As movement to the right position for exposure of mask MA2 takes place simultaneously with deceleration and acceleration of the table MT, no additional time is needed for exchanging a mask compared to conventional repeated exposure of just one mask pattern. Consequently, a high throughput is maintained.

Although in the above only mask tables comprising two masks are described, it may also be contemplated that the mask table comprises a plurality of masks or that the mask table comprises a relatively large mask comprising at least two patterns which may be similar in size to a pattern on one of the first and second masks. Whilst specific embodiments of the invention have been described above, it will be appreciated that the invention may be practiced otherwise than as described. The description is not intended to limit the invention.

## Claims

1. A device manufacturing method comprising:
providing a substrate (W) that is at least partially covered by a layer of radiation-sensitive material;
providing a projection beam (PB) of radiation using a radiation system;
providing first and second masks (MA1, MA2) having respective first and second patterns;
projecting the first pattern (MA1) onto a target portion of the layer of radiation-sensitive material; and
subsequently projecting the second pattern (MA2) onto the same target portion whilst relatively scanning the second pattern and the target portion before projecting one of the first and second patterns onto another target portion; **characterized in that**:
the first and second masks are arranged side-by-side on a single mask table in a direction substantially perpendicular to the directions in which the patterns and the target portions are scanned.

2. A method according to claim 1, wherein first pattern is projected while scanning said first pattern in a scan direction and the second pattern is subsequently projected while scanning said second pattern in a direction opposite to said scan direction.

3. A method according to claim 1 or 2, further comprising the step of displacing the mask table (MT) in a direction substantially perpendicular to the direction(s) of scan, between the steps of projecting the first pattern and projecting the second pattern.

4. A method according to claim 3, further comprising:
decelerating the mask table (MT) in the scan direction following projection of the first pattern;
accelerating the mask table (MT) in the direction opposite to the scan direction prior to projection of the second pattern; and wherein
the step of displacing the mask table (MT) is carried out during at least one of decelerating and accelerating the mask table.

5. A method according to any one of the preceding claims wherein the radiation system provides dipole illumination.

6. A lithographic projection apparatus comprising:
a radiation system (IL) for providing a projection beam of radiation;
a mask table (MT) for supporting a patterning means having a first pattern and a second pattern, the patterning means serving to pattern the projection beam according to a desired pattern;
a substrate table (WT) for holding a substrate;
drive means for relatively scanning the mask table at the substrate table in a scan direction and in a direction opposite to said scan direction; and
a projection system (PL) for projecting the patterned beam onto a target portion of the substrate, **characterized in that** the first and second patterns are provided on respective first and second masks (MA1, MA2) which are arranged on the mask table side-by-side in a direction substantially perpendicular to the scan direction.

7. Apparatus according to claim 6, wherein the apparatus is constructed and arranged to project the first pattern while scanning said first pattern in a scan direction and subsequently to project the second pattern while scanning said second pattern in a direction opposite to said scan direction.

8. Apparatus according to claim 6 or 7, wherein the apparatus is constructed and arranged to displace the support structure in a direction substantially perpendicular to the scan direction between the projection of the first pattern and projection of the second pattern.

9. Apparatus according to claim 6 or 7, further comprising:
positioning means constructed and arranged to decelerate the support structure in the scan direction following projection of the first pattern;
positioning means constructed and arranged to accelerate the support structure in the direction opposite to the scan direction prior to projection of the second pattern; and
wherein the apparatus is constructed and arranged to displace the support structure in a direction substantially perpendicular to the scan direction, during at least one of deceleration and acceleration of the support structure, such that the second pattern is positioned in line with the direction opposite to the scan direction.

10. Apparatus according to any one of claims 6 to 9, wherein the radiation system is arranged to provide dipole illumination.

## Patentansprüche

1. Verfahren zur Herstellung eines Bauelements, das folgende Schritte umfasst:
- Bereitstellen eines Substrats (W), das zumindest teilweise mit einer Schicht aus strahlungsempfindlichem Material bedeckt ist;
- Bereitstellen eines Projektionsstrahls (PB) aus Strahlung unter Verwendung eines Strahlungssystems;
- Bereitstellen von ersten und zweiten Masken (MA1, MA2) mit jeweils ersten und zweiten Mustern;
- Projizieren des ersten Musters (MA1) auf einen Zielbereich der Schicht aus strahlungsempfindlichem Material; und
- nachfolgendes Projizieren des zweiten Musters (MA2) auf den gleichen Zielbereich, während das zweite Muster und der Zielbereich jeweils vor dem Projizieren eines der ersten und zweiten Muster auf einen weiteren Zielbereich abgetastet werden; **dadurch gekennzeichnet, dass**:
die ersten und zweiten Masken nebeneinander auf einem einzelnen Maskentisch in einer Richtung angeordnet sind, die im wesentlichen senkrecht zu den Richtungen verläuft, in welche die Muster und die Zielbereiche abgetastet werden.

2. Verfahren nach Anspruch 1, wobei das erste Muster projiziert wird, während das erste Muster in einer Abtastrichtung abgetastet wird und das zweite Muster danach projiziert wird, während das zweite Muster in einer Richtung entgegen der Abtastrichtung abgetastet wird.

3. Verfahren nach Anspruch 1 oder 2, das zwischen dem Schritt des Projizierens des ersten Musters und dem Schritt des Projizierens des zweiten Musters ferner den Schritt des Verschiebens des Maskentisches /MT) in einer Richtung umfasst, die im wesentlichen senkrecht zur der/den Abtastrichtung/en verläuft.

4. Verfahren nach Anspruch 3, das ferner folgendes umfasst:
- Verlangsamen des Maskentisches (MT) in der Abtastrichtung nach Projizieren des ersten Musters;
- Beschleunigen des Maskentisches (MT) in der Richtung entgegen der Abtastrichtung vor dem Projizieren des zweiten Musters; und wobei
der Schritt des Verschiebens des Maskentisches (MT) während wenigstens einem der Schritte des Verlangsamens und des Beschleunigens des Maskentisches durchgeführt wird.

5. Verfahren nach einem der vorhergehenden Ansprüche, wobei das Strahlungssystem Dipolbeleuchtung bereitstellt.

6. Lithographische Projektionsvorrichtung, mit:
- einem Strahlungssystem (IL) zum Bereitstellen eines Projektionsstrahls aus Strahlung;
- einem Maskentisch (MT) zum Halten einer Musteraufbringungseinrichtung, die ein erstes und ein zweites Muster aufweist, wobei die Musteraufbringungseinrichtung dazu dient, den Projektionsstrahl gemäß einem gewünschten Muster zu mustern;
- einem Substrattisch (WT) zum Halten eines Substrats;
- Antriebseinrichtungen zum Abtasten des Maskentisches bei dem Substrattisch jeweils in eine Abtastrichtung und in eine Richtung entgegen der Abtastrichtung; und
- einem Projektionssystem (PL) zum Projizieren des gemusterten Strahls auf einen Zielbereich des Substrats, **dadurch gekennzeichnet, dass** das erste und das zweite Muster jeweils auf ersten und zweiten Masken (MA1, MA2) bereitgestellt wird, die nebeneinander auf dem Maskentisch in einer Richtung angeordnet sind, die im wesentlichen senkrecht zur Abtastrichtung verläuft.

7. Vorrichtung nach Anspruch 6, wobei die Vorrichtung so konstruiert und angeordnet ist, dass sie das erste Muster projiziert, während das erste Muster in einer Abtastrichtung abgetastet wird und danach das zweite Muster projiziert, während das zweite Muster in einer Richtung entgegen der Abtastrichtung abgetastet wird.

8. Vorrichtung nach Anspruch 6 oder 7, wobei die Vorrichtung so konstruiert und angeordnet ist, dass sie zwischen dem Projizieren des ersten Musters und dem Projizieren des zweiten Musters die Haltekonstruktion in einer Richtung verschiebt, die im wesentlichen senkrecht zur Abtastrichtung verläuft.

9. Vorrichtung nach Anspruch 6 oder 7, ferner mit:
- Positionierungseinrichtungen, die so konstruiert und angeordnet sind, dass sie die Haltekonstruktion in der Abtastrichtung nach dem Projizieren des ersten Musters verlangsamen;
- Positionierungseinrichtungen, die so konstruiert und angeordnet sind, dass sie die Haltekonstruktion in der Richtung entgegen der Abtastrichtung vor dem Projizieren des zweiten Musters beschleunigen; und
wobei die Vorrichtung so konstruiert und angeordnet ist, dass sie während wenigstens einem der Verlangsamungs- und Beschleunigungsschritte der Haltekonstruktion die Haltekonstruktion in einer Richtung verschiebt, die im wesentlichen senkrecht zur Abtastrichtung verläuft, so dass das zweite Muster in Reihe mit der Richtung entgegen der Abtastrichtung angeordnet ist.

10. Vorrichtung nach einem der Ansprüche 6 bis 9, wobei das Strahlungssystem Dipolbeleuchtung bereitstellt.

## Revendications

1. Procédé de fabrication de dispositif comprenant:
la fourniture d'un substrat (W) qui est au moins partiellement recouvert d'une couche de matériau sensible au rayonnement ;
la fourniture d'un faisceau de projection (PB) de rayonnement en utilisant un système de rayonnement ;
la fourniture des premier et second masques (MA1, MA2) ayant des premier et second motifs respectifs ;
la projection du premier motif (MA1) sur une partie cible de la couche de matériau sensible au rayonnement ; et
la projection ultérieure du second motif (MA2) sur la même partie cible tout en balayant de manière relative le second motif et la partie cible avant de projeter un des premier et second motifs sur une autre partie cible;
**caractérisé en ce que**:
les premier et second masques sont agencés côte à côte sur une table de masque unique dans une direction sensiblement perpendiculaire aux directions suivant lesquelles les motifs et les parties cible sont balayées.

2. Procédé selon la revendication 1, dans lequel le premier motif est projeté tout en balayant ledit premier motif dans une direction de balayage et le second motif est projeté ultérieurement tout en balayant ledit second motif dans une direction opposée à ladite direction de balayage.

3. Procédé selon la revendication 1 ou 2, comprenant de plus l'étape consistant à déplacer la table de masque (MT) dans une direction sensiblement perpendiculaire à la direction ou aux directions de balayage, entre les étapes de projection du premier motif et de projection du second motif.

4. Procédé selon la revendication 3, comprenant de plus:
la décélération de la table de masque (MR) dans la direction de balayage après projection du premier motif ;
l'accélération de la table de masque (MT) dans la direction opposée à la direction de balayage avant la projection du second motif ; et dans lequel
l'étape de déplacement de la table de masque (MT) est effectuée pendant l'une au moins parmi la décélération et l'accélération de la table de masque.

5. Procédé selon l'une quelconque des revendications précédentes, dans lequel le système de rayonnement fournit un éclairement dipolaire.

6. Appareil de projection lithographique comprenant :
un système de rayonnement (IL) pour fournir un faisceau de projection de rayonnement ;
une table de masque (MT) pour supporter des moyens de formation de motif ayant un premier motif et un second motif, les moyens de formation servant à munir d'un motif le faisceau de projection selon un motif voulu ;
une table de substrat (WT) pour maintenir un substrat ;
des moyens d'entraînement pour balayer de manière relative la table de masque au niveau de la table de substrat dans une direction de balayage et dans une direction opposée à ladite direction de balayage ; et
un système de projection (PL) pour projeter le faisceau muni d'un motif sur une partie cible du substrat, **caractérisé en ce que** les premier et second motifs sont agencés sur des premier et second masques (MA1, MA2) respectifs qui sont agencés sur la table de masque côte à côte dans une direction sensiblement perpendiculaire à la direction de balayage.

7. Appareil selon la revendication 6, dans lequel l'appareil est construit et agencé pour projeter le premier motif tout en balayant ledit premier motif dans une direction de balayage et ultérieurement pour projeter le second motif tout en balayant ledit second motif dans une direction opposée à ladite direction de balayage.

8. Appareil selon la revendication 6 ou 7, dans lequel l'appareil est construit et agencé pour déplacer la structure de support dans une direction sensiblement perpendiculaire à la direction de balayage entre la projection du premier motif et la projection du second motif.

9. Appareil selon la revendication 6 ou 7, comprenant de plus:
des moyens de positionnement construits et agencés pour décélérer la structure de support dans la direction de balayage après projection du premier motif ;
des moyens de positionnement construits et agencés pour accélérer la structure de support dans la direction opposée à la direction de balayage avant la projection du second motif ; et
dans lequel l'appareil est construit et agencé pour déplacer la structure de support dans une direction sensiblement perpendiculaire à la direction de balayage, pendant l'une au moins parmi la décélération et l'accélération de la structure de support, de sorte que le second motif est positionné en ligne avec la direction opposée à la direction de balayage.

10. Appareil selon l'une quelconque des revendications 6 à 9, dans lequel le système de rayonnement est agencé pour fournir un éclairement dipolaire.
